# EUROPEAN PATENT SPECIFICATION

(11) **EP 0 418 777 B1**
(45) Date of publication and mention of the grant of the patent: **13.12.1995**
(21) Application number: 90117852.5
(22) Date of filing: 17.09.1990
(51) Int. Cl.: H01L 27/04, H01L 23/485

(54) **Wafer scale semiconductor device**
Halbleiteranordnung auf Scheibenskala
Dispositif semi-conducteur à l'échelle de la plaquette

(30) Priority: 19.09.1989 JP 242674/89
(43) Date of publication of application: 27.03.1991
(73) Proprietor: FUJITSU LIMITED, Kawasaki-shi, Kanagawa 211 (JP)
(72) Inventor: Suzuki, Takaaki, Kawasaki-shi, Kanagawa 214 (JP); Tokoro, Masahiro, Kawasaki-shi, Kanagawa 211 (JP); Nomura, Yukihiro, Kawasaki-shi, Kanagawa 213 (JP); Tatematsu, Takeo, Sagamihara-shi, Kanagawa 229 (JP)
(74) Representative: Seeger, Wolfgang, Dipl.-Phys.

(56) References cited:
- EP-A- 0 100 100
- EP-A- 0 128 799
- WO-A-89/12320
- GB-A- 2 178 204
- US-A- 3 971 062
- PATENT ABSTRACTS OF JAPAN, vol. 9, no. 95 (E-310)[1818], 24th April 1985 ; & JP-A-59 222 952

## Description

The present invention relates to a wafer scale semiconductor device composed of a semiconductor wafer comprising a plurality of chips arranged in a matrix fashion and interconnected by bonding wiring in a wafer scale integration (WSI) composed by connecting the chips formed on the semiconductor wafer.

The WSI has a structure wherein circuits are integrated in all areas of a wafer and has the following advantages
1) A larger scale circuit than in any LSI (Large scale integrated circuit) can be integrated.
2) A mutual wiring or interconnection length between circuits becomes short by integrating a system on one wafer, and the signal delay time can be shortened.
3) The system reliability can be improved by an improvement in reliability of packaging by the reduction of the assembly process, or a defect relief technique.

The WSI is suitable for forming a repeated logic circuit in which basic circuits are connected to each other and to a memory monolithically.

In a case of a monolithic WSI, since circuits are integrated on a wide area including defect parts, a technique of redundancy in structure and detour around defects is indispensable.

### 2. Description of the Related Art

When in a wafer scale memory which is a conventional kind of WSI, the main flat direction of an orientation is assumed as an X direction, and the direction perpendicular to the X direction is assumed as a Y direction. The X and Y directions between each chip are connected to each other on a data line, the memory is formed in such a manner that when a signal is applied from the input terminal, the signal detours around defective chips and serially passes through only non-defective chips and appears at an output terminal. Further in a Y direction the chips are connected in parallel to each other on a control line, a wafer clock, a V_{CC} line, a V_{SS} line a V_{BB} line, etc. (Japanese Examined Patent Publications 58-18778 and 62-6267).

Each chip is connected to the other chips by data lines while logic circuits are of course intervened.

In the above-mentioned wafer scale memory the mutual wiring length between circuits becomes shorter than in a case where each die chip is connected to each of the other chips. Nevertheless, when a power source such as a V_{CC} line, a V_{SS} line, etc., is formed with a metal wiring of Al, etc., on a wafer, the resistance value becomes comparatively large.

In a conventional wafer scale memory, four corners of a wafer are cut by cutting circumferential edges in both X and Y directions so that a substantial rectangle is formed and the cut wafer is used by being mounted on a carrier. In this case, a cut region obtained by a blade has problems. Further, when a control line and a wafer clock or a data line is formed by an Al wiring, etc., formed on a wafer, a shortcircuiting is apt to occur at the circumferential edges of a wafer.

To overcome the problems the present applicant filed a wafer scale memory as Japanese Patent Application No. 63-132589 corresponding to earlier application W089/12320.

The wafer scale memory provides metal pads which act as relay points of a bonding wire selectively formed at a desired position of the circumferential area of a wafer on the surface thereof, dummy chips having a cutting line in which at least a metal film does not exist, real chips which are selectively disposed in a desired center portion of the wafer and a control line and a wafer clock separated near the interface of the neighboring chip so that a data line can be passed and power source lines formed by a bonding wire can be connected to each chip.

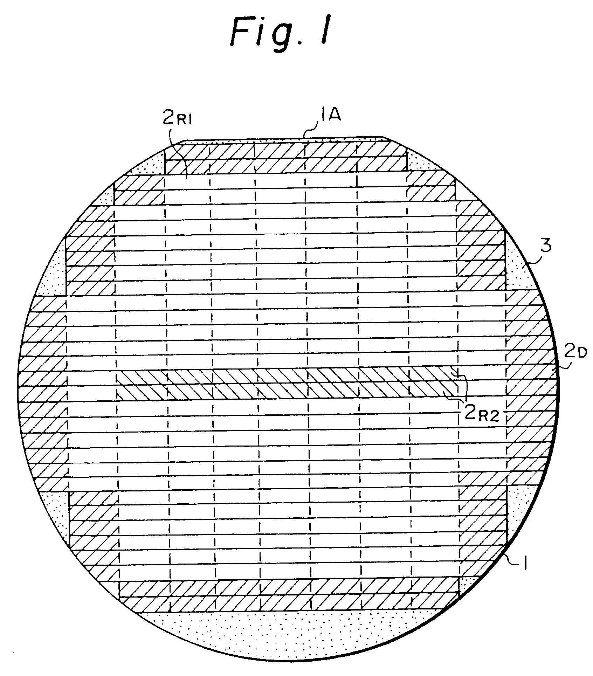

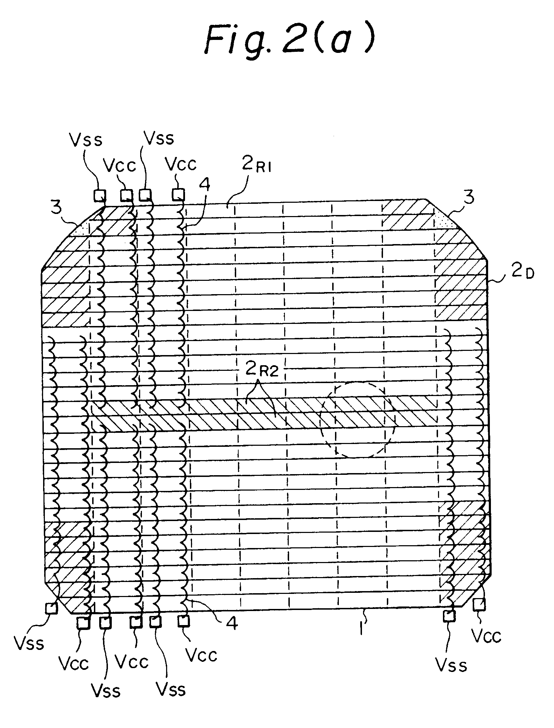

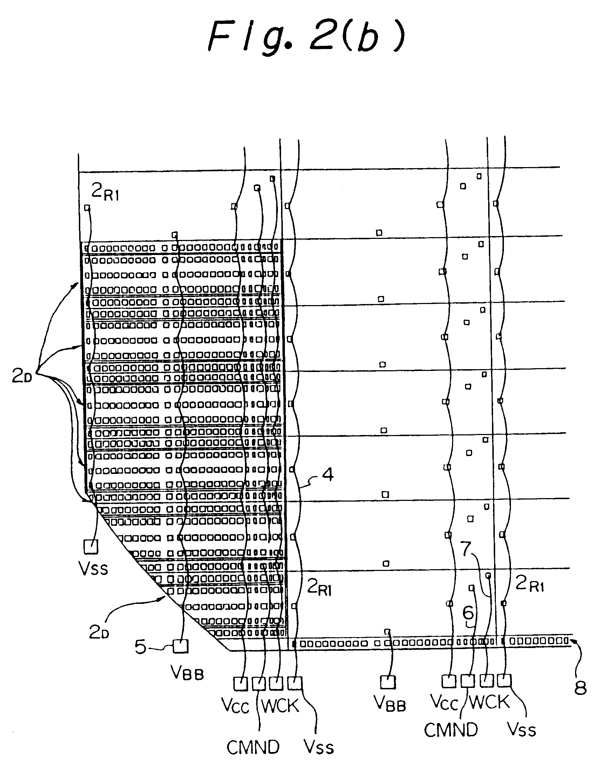

A conventional example will now be explained with reference to Figures 1, 2(a) and 2(b).

Fig. 1 is a plan view of a wafer before being cut to form a wafer scale memory and Fig. 2(a) is a plan view showing a wafer with four cut circumferential sides to adapt it to a carrier for mounting and Fig. 2(b) is an enlarged plan view of a lower left portion of Fig. 2(a).

In Figs. 1 and 2, reference numeral 1 is a wafer, 1A an orientation flat, 2_{R1} and 2_{R2} real chips (actually operating chips), 2_{D} dummy chips, 3 metal films and 4 power source lines of bonding wire V_{CC} lines and V_{SS} lines.

The real chips 2_{R1} shown in Fig. 1 are the same as the prior art. On the other hand, the real chips 2_{R2} have separated control. lines and wafer clocks near the neighboring interface. Further, dummy chips 2_{D} have an electrically floating state to relay bonding wires and have metal pads of Al, etc., while forming cutting lines with no metal film or passivation film.

As explained above, in the conventional wafer scale memory, dummy chips are formed at the circumferential edge of the wafer 1 and even if the power source lines 4 such as V_{CC} lines and V_{SS} lines are formed by using bonding wires, the dummy chips 20 can be used as relay points and long wires are not required to as great an extent.

As shown in Fig. 2, even a dummy chip cannot be formed at the right and left upper corner on the orientation flat 1A side so a slightly longer wire is required. Nevertheless, in pattern baking the long wire can possibly be shortened by shifting all chips so that they approach the orientation flat.

The pattern shown in Figs. 1 and 2 is formed relatively near the orientation flat. Thus, even in a left and right upper corner of a wafer, where a long wire is needed, a shorter wire than in a prior art can be used. Furthermore, when the side opposite to the orientation flat is cut, metal film 3 is not left at the left and right lower corners of the wafer. Additionally, in chip rows at both left and right sides the real chip 2_{R2} which separates both the control line and the wafer clock, is not used. The power source line 4 is wire-ringed only from the left and right lower corner of the wafer so that a long wiring can be avoided.

Therefore, the power source line 4 does not make a short-circuit at all with a metal film 3 positions at an edge of the wafer 1, and even if the control line and the wafer clock or the data line are extended they do not make a short circuit near the wafer 1.

In fig. 2(b), the same references as in Figs. 1 and 2(a) indicate the same portions or same meanings as therein. In Fig. 2(b), referemce 6 denotes a command strobe (CMND) signal transmitting line, 7 denotes a wafer clock (WCK) signal transmitting line, 8 denotes a metal pad of a relay point in the terminal chip 2_{D}, and V_{BB} denotes a substrate voltage supply line. The terminal chip 2_{D} has a plurality of metal pads made of aluminium and the like for relaying a bonding wire, each of the metal pads is at an electrically floating state. When forming the terminal chip 2_{D} shown in Fig. 2 onto the wafer, for example metal pads 8 made of aluminium and a cover film (which is not indicated in the drawing) are printed on the terminal chip 2_{D}, and the other processes are not carried out.

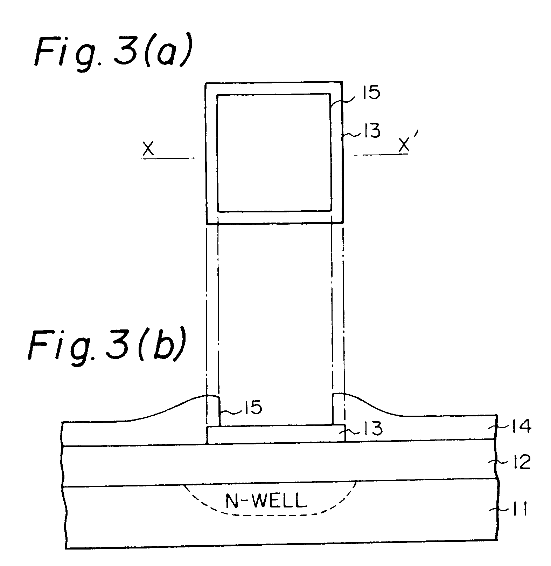

Figures 3 (a) and (b) are views showing a metal pad for bonding in an electrically floating state to relay bonding wires, which metal pad is formed on the dummy chip 2_{D} particularly. Fig. 3 (a) is a plan view and Fig. 3 (b) is a cross-sectional view taken along the line X-X′.

In Figs. 3 (a) and (b) the reference numeral 11 is a substrate of Si for example, 12 an insulating film of SiO₂ , for example, 13 an electrically floating conductor layer which is made of for example, Al and is brought into contact with a bonding wire, 14 is an insulating film (cover film) which is made of for example SiO₂ and protects a bonding pad, and 15 is a contact window.

In the above mentioned conventional wafer scale memory. The dummy chips 2_{D} are positioned at the circumferential portion of a wafer as shown in Figs. 1 and 2, the chips 2_{D} have influences of foreign particles, defects in a wafer process, problems during wire bonding, and the insulating film 12 between the conductor layer 13 brought into contact with a bonding wire and the substrate 11 is apt to be broken.

Particularly in a bonding in a wafer scale integration, an entire wafer is used and since a number of pads of relay point dummy chips are used the opportunity of bonding is increased and above mentioned disadvantages are increased.

Furthermore in a method for producing a wafer scale memory, many complex processes such as formation of a well in a substrate are included. Thus the reduction of steps is required.

Document EP-A-0100100 discloses that a poly-silicon layer formed under a bonding pad absorbs a bonding shock.

### SUMMARY OF THE INVENTION

It is an object of the present invention to provide a wafer scale semiconductor device wherein influences of dust, flaws in a wafer process, and problems during wire bonding can be decreased.

It is another object of the present invention to provide a wafer scale semiconductor device suitable for wafer scale integration.

It is a further object of the present invention to provide a wafer scale semiconductor device whose production steps can be shortened.

These objects are achieved by the features of claim 1.

The buffer layer is preferably made of a material which is not etched by an etchant which etches the insulating layer.

Further, according to the present invention the buffer layer is preferably formed as a seat layer of Poly-Si, TiN or Si₃N₄ in a case where said insulating layer is made of SiO₂ , and the size of the buffer layer is preferably a little larger than that of the conductor layer.

### BRIEF DESCRIPTION OF THE DRAWINGS

Fig. 1 is a plan view of a wafer which is used in a wafer scale memory,
Fig. 2 is a plan view of an edge-cut wafer which is used in a wafer scale memory,
Fig. 3 is a view of a structure of a conventional metal pad for bonding,
Fig. 4 is a view of an example of a structure of a metal pad for bonding in a wafer scale semiconductor device according to the present invention,
Fig. 5 is a view of an example of a structure of a metal pad for bonding having a resin coating according to the present invention, and
Fig. 6 is a view explaining a method for the metal pad for bonding according to the present invention.

### PREFERRED EMBODIMENTS OF THE INVENTION

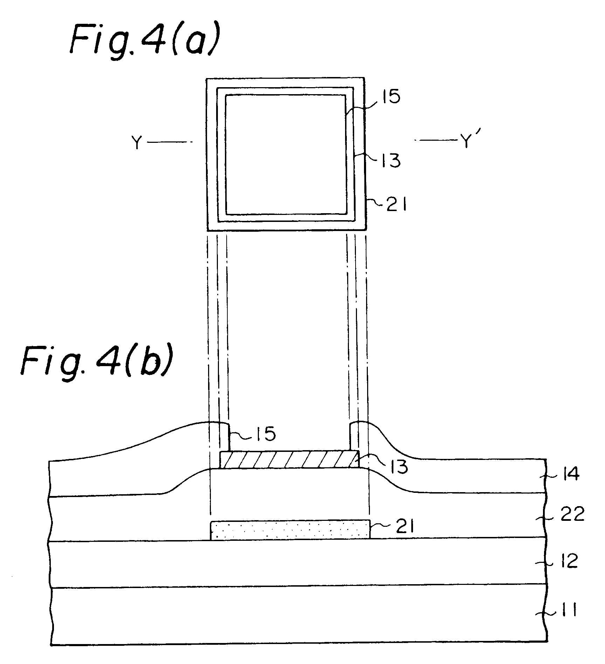

Figures 4 to 6 are views showing an example of a wafer scale semiconductor. This example is one applied to a bonding pad formed on dummy chips in a wafer scale integration.

The same elements as in Figs. 1 to 3 are denoted by the same reference numbers.

Fig. 4 (a) is a plan view showing a structure of a metal pad for bonding and Fig. 4 (b) is a cross-sectional view taken along Y-Y′ of Fig. 4 (a). As shown in Figs. 4 (a) and (b), an oxide film (SiO₂ film) 12 is formed on a Si substrate 11. On the SiO₂ film 12, a poly silicon (Si) seat layer 21 is formed.

The poly silicon (Poly-Si) is not etched by an etchant by which an SiO₂ insulating film 22 formed on the Poly Si sheet layer 21 and the SiO₂ film 12 is etched. In this case, to shorten the step a field oxide film may not be used as the oxide film 12. Further, to shorten the step a layer which is not completely etched off may be left between the oxide film 12 and the poly-Si layer 21.

An electrically floating conductor layer 13 of for example Al, which is brought into contact with a bonding wire is formed on the SiO₂ insulating film 22. On the SiO₂ insulating film 22, is a SiO₂ film 14 which covers a bonding pad (not shown).

The poly Silicon seat layer 21 may be formed under the conductor layer 13 with a corresponding size thereto and is preferably patterned with a size a little larger than that of the conductor layer 13. Titanium nitride (TiN) or silicon nitride (Si₃N₄), etc., which has a different etching rate from that of the insulating film 22, can be used in place of Poly-Si.

As the conductor layer 13 which is brought into contact with a bonding wire, not only a single Al layer as described in the example but also a two layer structure of an Al layer and an Al-Si layer or a Poly-Si layer under the Al layer can be used.

In Fig. 4, a SiO₂ cover insulating film 14 is used as a single layer. Nevertheless, a plurality of insulating layers can be also used.

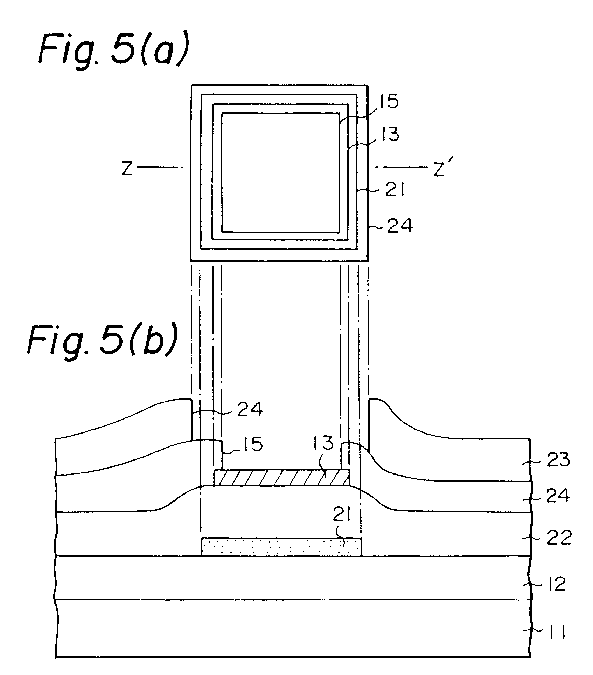

Figure 5 shows such an example. Namely, in Fig. 5 two insulating layers are formed. Fig. 5 (a) shows a plan view of a structure of a metal pad for bonding and Fig. 5 (b) shows a cross-sectional view taken along line Z-Z′. The same elements in Fig. 5 (a) and (b) as in Figs. 4 (a) and (b) are denoted by the same reference numerals.

In Figs. 5 (a) and (b), a resin coating film 23 is formed on a SiO₂ insulating film 14. The insulating film 14 and the resin coating film 23 act as an electrical insulator and protect the substrate and the resin coating film 23 prevents invasion of water into the interior. The reference numeral 24 is a coating window of the resin coating film 23.

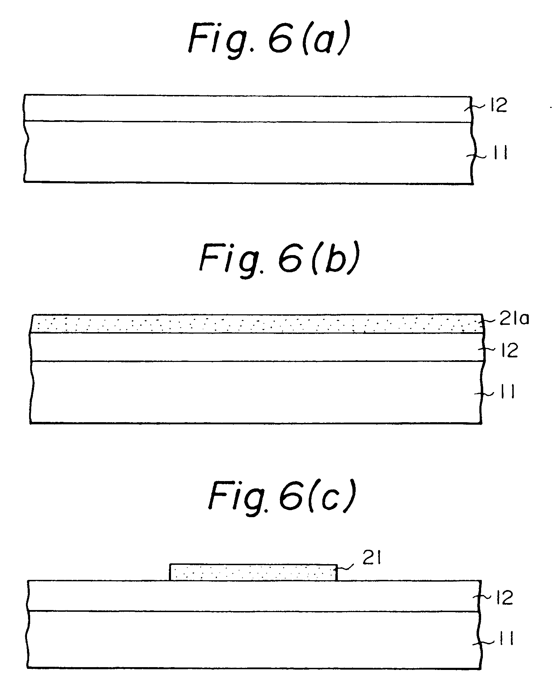

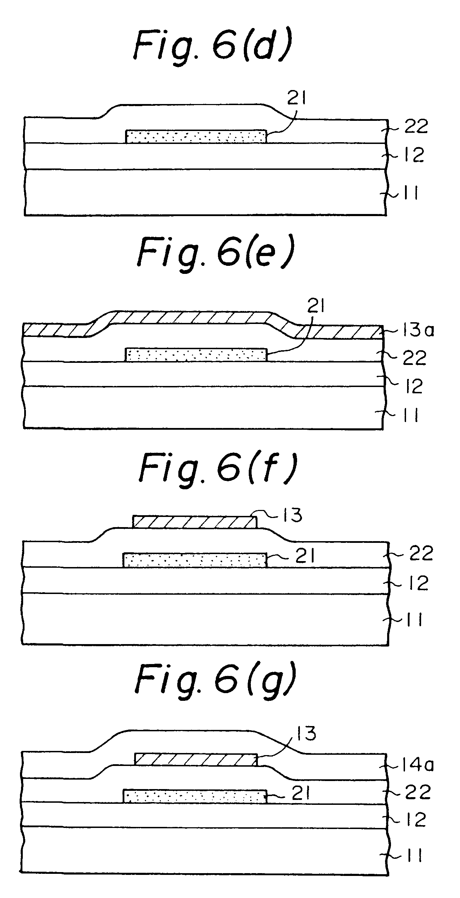

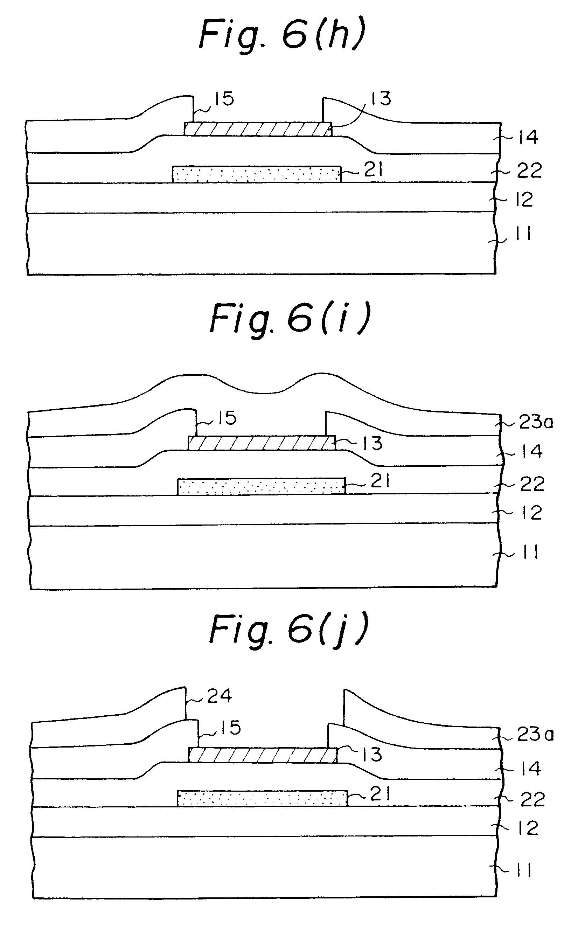

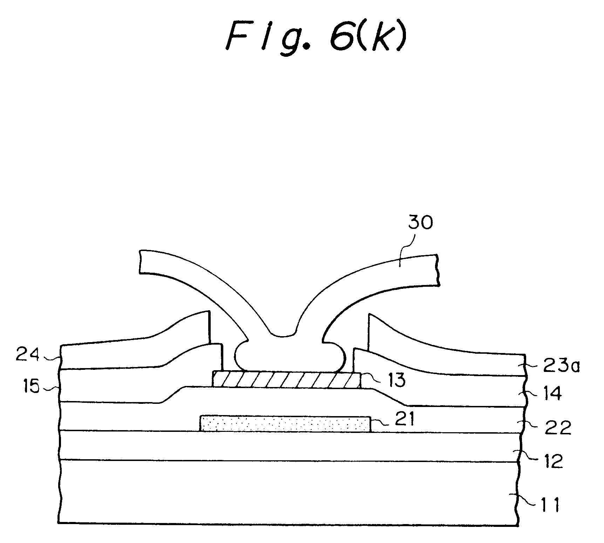

Next, a method for producing a metal pad for bonding will be explained with reference to Figs. 6 (a) to (j).

First, as shown in Fig. 6 (a), a field SiO₂ insulating film 12 having a thickness of 2000 to 8000 Å is formed on a Si substrate 11 by thermal oxidation.

Next, as shown in Fig. 6 (b), on the field SiO₂ insulating film 12 a Poly-Si layer 21a having a thickness of 1000 to 4000 Å is grown on the field SiO₂ insulating film 12 by for example, a well known CVD process.

Then, as shown in Fig. 6 (c), by using a photolithography on the Poly-Si layer 21a, a seat layer 21 a little larger than the conductor layer 13 which is to be brought into contact with a bonding wire is formed.

Then, as shown in Fig. 6 (d), on the insulating film 12 and the seat layer 21 a SiO₂ insulating film 22 having a thickness of 5000 to 10000 Å is grown and on the SiO₂ film 22 an Al layer 13a having a thickness of 4000 to 10000 Å is formed by, for example, a sputtering process or a CVD process as shown in Fig. 6 (e).

After that, as shown in Fig. 6 (f), by using a photolithography process, an Al layer 13a is patterned to form a conductor layer 13 which is brought into contact with a bonding wire having a pad structure.

Then, as shown in Fig. 6 (g), on the insulating film 22 and the conductor 13, a SiO₂ film 14a having a thickness of 2000 to 8000 Å and acting as an insulating film 14 is grown by a CVD process, for example, and as shown in Fig. 6 (h), a SiO₂ film 14a is etched by a photolithography technique so that a contact hole 15 for a bonding wire is formed.

Then, as shown in Fig. 6 (i) a resin coating 23a having a thickness of 1.0 to 2.0 »m is formed on the entire surface of the insulating film and the conductor layer 13 and patterned by a photolithography technique so that a window 24 is formed, as shown in Fig. 6 (j), with the result that a metal pad(13) for bonding can be realized. The metal pad(13) in a portion of a real chip may have a structure of Fig. 3.

After that, on the metal pad(13), a bonding wire 30 can be formed by a stitch bonding process as shown in Fig. 6(K).

Namely, in the example, the structure of a metal pad for bonding has an electrically floating conductor layer 13 which is brought.into contact with a bonding wire, an insulating film 22 positioned under the conductor 13 and a seat layer 21 provided under the conductor 13 through the insulating film 22 and made of a material, for example, Poly-Si, which is not etched by an etchant by which the insulating film 22 is etched. The seat layer 21 is patterned with a larger size than that of the conductor layer 13 which is brought into contact with the bonding wire. Further, an insulating film 12 is formed to be electrically isolated from the substrate 11.

Thus, by providing the seat layer 21 and the conductor layer 13 which is brought into contact with a bonding wire in a manner that they sandwich the insulating Film 22, the following advantages can be obtained.

(I) Even if the insulating film 22 is broken by damage during the bonding process and the conductor layer 13 is brought into contact with the seat layer 21, the seat layer 21 made of a soft material such as Poly-Si, etc., acts as a buffer layer so that it absorbs shock and does not transfer the shock to the underlayer.

Furthermore, since each seat layer 21 has an independent seat structure, even if an insulating film 22 is broken and is connected to a seat layer 21 brought into contact with a bonding wire, the seat layer 21 does not had a negative influence such as a short, on the neighboring seat layer 21 or the neighboring conductor layer 13 brought into contact with a bonding wire. If the seat layer 21 has different material or structure from that of the insulating film 22 it can act as a buffer layer.

(II) Even if the insulating film 22 under the conductor layer 13 is etched by process problem, etc., the etching is stopped at the seat layer 21 and the insulating film 12 between the seat layer 21 and the substrate 13 remains so that the insulation can be maintained.

For example, when, after forming a resist layer an insulating film is selectively etched, and the resist layer has a crack or pinhole, the insulating film just under such defect is disadvantageously etched. Nevertheless, since in the present invention, a seat layer 21 having a material which is not etched by an etchant used in forming the insulating film, is used, as explained above, even if the insulating film is etched the layer under the seat layer 21 is not etched and remains.

Particularly, when the present invention as described in the example is applied to a WSI having a number of metal pads which act as relay points on dummy chips 2_{D} and having many opportunities of bonding, the above-mentioned effects (I) and (II) are remarkable.

## Claims

1. A wafer scale semiconductor device formed in a semiconductor wafer (1), comprising:
a plurality of dummy chips (2D) selectively formed in circumferential edge regions of said wafer, each of said dummy chips (2D) having a plurality of metal bonding pads (8) which act as relay points for connection to bonding wires, said dummy chips being formed in cutting line regions with no metal film on said wafer, each of said bonding pads (8) of said dummy chips being electrically floating;
a plurality of real chips (2R) formed in a centre portion of said wafer and interconnected to each other by control lines and wafer clock lines, each of said plurality of real chips (2R) having actually operating circuits and bonding pads including pads for power supply lines and pads for control signal lines;
a plurality of stich-bonded bonding wires, each connecting an external terminal formed outside said semiconductor wafer to one of said bonding pads of a dummy chip and to one of said bonding pads of said real chips, said bonding wires being arranged in a first direction;
a plurality of said bonding wires being bonded to respective ones of said bonding pads (8) of said plurality of dummy chips (2D) from respective ones of said external terminals connected to said power supply lines and extending to respective ones of said bonding pads of adjoining ones of said plurality of real chips and further extending to respective ones of said bonding pads of further adjacent ones of said real chips in said first direction;
each of said electrically floating-state bonding pads (8) comprising:
a conductor layer (13) contactable with one of said bonding wires;
an insulating layer (22) formed under said conductor layer for insulating said conductor layer from said wafer; and
a buffer layer (21) having the shape of said conductor layer (13) for shock absorbing formed under said insulating layer (22) and below said conductor layer (13);
wherein said buffer layer (21) is formed in each of said floating-state bonding pads of said plurality of dummy chips (2D) and is not present in said bonding pads of said plurality of real chips (2R).

2. A device according to claim 1, wherein said buffer layer (21) is made of a material which is not etched by an etchant which etches said insulating layer (22).

3. A device according to claim 1, wherein said buffer layer is formed as a seat layer of Poly-Si, TiN or Si₃N₄ and said insulating layer is made of SiO₂.

4. A device according to claim 1, wherein the size of said buffer layer is larger than that of said conductor layer.

5. A device according to claim 1, wherein said conductor layer (13) has a thickness of 400 to 1000 nm, said insulating layer (22) has a thickness of 500 to 1000 nm and said buffer layer (21) has a thickness of 100 to 400 nm.

## Patentansprüche

1. Halbleitervorrichtung in Wafergröße, die in einem Halbleiterwafer (1) geformt ist, mit:
einer Vielzahl von Dummy-Chips (2D), die selektiv in den Umfangsrandbereichen des Wafers gebildet sind, wobei jeder der Dummy-Chips (2D) eine Vielzahl von Metallbondinganschlußfeldern (8) hat, die als Relaispunkte zur Verbindung mit Bondingdrähten dienen, wobei die Dummy-Chips in Schnittlinienbereichen ohne Metallfilm auf dem Wafer gebildet sind, wobei jedes der Bondinganschlußfelder (8) der Dummy-Chips elektrisch schwebend ist;
einer Vielzahl von realen Chips (2R), die in einem Mittelteil des Wafers gebildet sind und die miteinander durch Steuerleitungen und Wafertaktleitungen verbunden sind, wobei jede der Vielzahl von realen Chips (2R) tatsächlich arbeitende Schaltkreise und Bondinganschlußfelder, einschließlich Anschlußfelder für Energieversorgungsleitungen und Anschlußfelder für Steuersignalleitungen, hat;
einer Vielzahl von stichverbundenen Bondingdrähten, die jeweils ein externes Terminal, das außerhalb des Halbleiterwafers gebildet ist, mit einem der Bondinganschlußfelder eines Dummy-Chips verbinden sowie mit einem der Bondinganschlußfelder der realen Chips, wobei die Bondingdrähte in einer ersten Richtung angeordnet sind;
wobei eine Vielzahl der Bondingdrähte an die jeweiligen Bondinganschlußfelder (8) der Vielzahl von Dummy-Chips (2D) von den jeweiligen externen Terminals, die mit den Energieversorgungsleitungen verbunden sind, gebondet sind und sich bis zu den jeweiligen Bondinganschlußfeldern der angrenzenden Chips der Vielzahl von realen Chips erstrecken und sich weiter bis zu den jeweiligen Bondinganschlußfeldern weiterer angrenzender realer Chips in einer ersten Richtung erstrecken;
wobei ein jedes der in elektrisch schwebendem Zustand befindlichen Bondinganschlußfelder (8) umfaßt:
eine Leiterschicht (13), die mit einem der Bondingdrähte verbindbar ist;
eine Isolationsschicht (22), die unter der Leiterschicht geformt ist, um die Leiterschicht von dem Wafer zu isolieren; und
eine Pufferschicht (21), die die Form der Leiterschicht (13) hat, zur Stoßabsorption, und unter der Isolationsschicht (22) und unter der Leiterschicht (13) gebildet ist;
wobei die Pufferschicht (21) in jedem der Bondinganschlußfelder in schwebendem Zustand der Vielzahl von Dummy-Chips (2D) gebildet ist und in den Bondinganschlußfeldern der Vielzahl der realen Chips (2R) nicht vorhanden ist.

2. Vorrichtung nach Anspruch 1, bei der die Pufferschicht (21) aus einem Material gemacht ist, das nicht durch ein Ätzmittel geätzt wird, das die Isolationsschicht (22) ätzt.

3. Vorrichtung nach Anspruch 1, bei der die Pufferschicht als Sitzschicht aus Poly-Si, TiN oder Si₃N₄ gebildet ist und die Isolationsschicht aus SiO₂ gemacht ist.

4. Vorrichtung nach Anspruch 1, bei der die Größe der Pufferschicht größer als diejenige der Leiterschicht ist.

5. Vorrichtung nach Anspruch 1, bei der die Leiterschicht (13) eine Dicke von 400 bis 1.000 nm, die Isolationsschicht (22) eine Dicke von 500 bis 1.000 nm und die Pufferschicht (21) eine Dicke von 100 bis 400 nm hat.

## Revendications

1. Dispositif à semiconducteur pleine plaquette formé dans une plaquette semiconductrice (1), comprenant:
une pluralité de puces fictives (2D) formées sélectivement dans des régions de bord circonférentiel de ladite plaquette, chacune desdites puces fictives (2D) comportant une pluralité de plots de liaison en métal (8) qui jouent le rôle de points de relais pour une connexion à des fils de liaison, lesdites puces fictives étant formées dans des régions de ligne de découpe où il n'y a aucun film de métal sur ladite plaquette, chacun desdits plots de liaison (8) desdites puces fictives étant électriquement flottant;
une pluralité de puces réelles (2R) formées dans une partie centrale de ladite plaquette et interconnectées les unes aux autres par des lignes de commande et par des lignes d'horloge de plaquette, chacune de ladite pluralité de puces réelles (2R) comportant des circuits fonctionnant réellement et des plots de liaison incluant des plots pour des lignes d'alimentation et des plots pour des lignes de signal de commande ;
une pluralité de fils de liaison liés par boucle, chacun connectant une borne externe formée à l'extérieur de ladite plaquette semiconductrice à l'un desdits plots de liaison d'une puce fictive et à l'un desdits plots de liaison desdites puces réelles, lesdits fils de liaison étant agencés suivant une première direction;
une pluralité desdits fils de liaison étant liés à certains respectifs desdits plots de liaison (8) de ladite pluralité de puces fictives (2D) depuis certaines respectives desdites bornes externes connectées auxdites lignes d'alimentation et s'étendant jusqu'à certains respectifs desdits plots de liaison de certaines attenantes de ladite pluralité de puces réelles et s'étendant en outre jusqu'à certains respectifs desdits plots de liaison d'encore certaines adjacentes desdites puces réelles suivant ladite première direction;
chacun desdits plots de liaison dans l'état électriquement flottant (8) comprenant:
une couche conductrice (13) qui peut être mise en contact avec l'un desdits fils de liaison ;
une couche isolante (22) formée sous ladite couche conductrice pour isoler ladite couche conductrice par rapport à ladite plaquette; et
une couche tampon (21) présentant la forme de ladite couche conductrice (13) pour absorber les chocs formée sous ladite couche isolante (22) et au-dessous de ladite couche conductrice (13),
dans lequel ladite couche tampon (21) est formée dans chacun desdits plots de liaison à l'état flottant de ladite pluralité de puces fictives (2D) et n'est pas présente dans lesdits plots de liaison de ladite pluralité de puces réelles (2R).

2. Dispositif selon la revendication 1, dans lequel ladite couche tampon (21) est réalisée en un matériau qui n'est pas gravé par un agent de gravure qui grave ladite couche isolante (22).

3. Dispositif selon la revendication 1, dans lequel ladite couche tampon est formée en tant que couche d'assise en polysilicium, en TiN ou en Si₃N₄ et ladite couche isolante est réalisée en SiO₂.

4. Dispositif selon la revendication 1, dans lequel la taille de ladite couche tampon est plus importante que celle de ladite couche conductrice.

5. Dispositif selon la revendication 1, dans lequel ladite couche conductrice (13) présente une épaisseur de 400 à 1000 nm; ladite couche isolante (22) présente une épaisseur de 500 à 1000 nm et ladite couche tampon (21) présente une épaisseur de 100 à 400 nm.
